# EUROPÄISCHE PATENTSCHRIFT

(11) **EP 0 303 059 B1**
(45) Veröffentlichungstag und Bekanntmachung des Hinweises auf die Patenterteilung: **17.03.1993**
(21) Anmeldenummer: 88111121.5
(22) Anmeldetag: 12.07.1988
(51) Int. Cl.: G01R 31/00

(54) **Diagnosesystem für Steuergeräte eines Kraftfahrzeugs**
Diagnostic system for the control units of a motor vehicle
Système de diagnostic pour appareil de réglage d'un véhicule

(30) Priorität: 07.08.1987 DE 3726344
(43) Veröffentlichungstag der Anmeldung: 15.02.1989
(73) Patentinhaber: Dr.Ing.h.c. F. Porsche Aktiengesellschaft, 70435 Stuttgart (DE)
(72) Erfinder: Staffe, Detlef, D-7143 Vaihingen/Enz (DE)

(56) Entgegenhaltungen:
- EP-A- 0 072 000
- EP-A- 0 231 607
- DE-A- 3 309 867
- DE-A- 3 324 100
- DE-A- 3 440 555
- DE-A- 3 540 599
- US-A- 4 395 624

## Beschreibung

Die Erfindung betrifft ein Diagnoseverfahren für ein Diagnosesystem Anspruchs 1 und ein Testgerät zur Durchführung dieses Diagnoseverfahrens.

Wegen des ständig wachsenden Funktionsumfangs und der immer größer werdenden Anzahl von elektronischen Steuergeräten in Kraftfahrzeugen werden zunehmend Diagnosesysteme für diese mit Fehlerspeichern und Selbst-Diagnosefunktionen ausgestatteten Steuergeräte eingesetzt. Die Steuergeräte sind hierzu im allgemeinen über einen Diagnosebus miteinander verbunden, an dem ein externes oder fahrzeugeigenes Testgerät anschließbar ist.

Neben großen und teuren Werkstatt-Testgeräten, mit welchen eine vollautomatische Diagnose mit Fehlerausgabe im Klartext möglich ist, gelangen in zunehmendem Maße auch die sehr einfachen und kostengünstigen Diagnosesysteme mit BlinkcodeAusgabe zum Einsatz; diese einfachen Diagnosesysteme können sich auch kleinere Werkstätten anschaffen.

Mit einem derartigen Diagnosesystem sind beispielsweise die selbstdiagnosefähigen Kraftstoffeinspritz-Steuergeräte LH-Jetronic LH 2.3, die Zündsteuergeräte EZ 121K und die Motorsteuergeräte Motronic M 2.1 der Fa. Bosch ausgestattet (siehe beispielsweise SAE-Paper 840 541). Diese Steuergeräte sind im Kraftfahrzeug über eine Reizleitung und eine Fehlerlampenleitung miteinander verbunden. Über eine Steckverbindung wird an die Reizleitung ein Taster angeschlossen, mit dem diese gegen Masse geschaltet werden kann. Eine Fehlerlampe (Leuchtdiode) wird entweder im Armaturenbrett des Kraftfahrzeugs angeordnet oder mit dem Taster in einem gemeinsamen Gehäuse baulich vereinigt.

Mit diesem einfachen Testgerät ist nun eine Diagnose der oben genannten Steuergeräte und auch weiterer, selbstdiagnosefähiger Steuergeräte (sofern sie dafür eingerichtet sind, beispielsweise einer Ladedruckregelung, eines Antiblockiersystems, einer Klimaanlage usw. möglich), d. h., die in diesen Testgeräten angeordneten Fehlerspeicher können damit ausgelesen werden; im Fehlerspeicher werden Fehler, die während des Betriebs des Steuergeräts im Steuergerät selbst oder an seiner Peripherie aufgetreten sind, abgelegt. Ebenso ist beispielsweise eine Diagnose der vom Steuergerät betätigten Stellglieder möglich, sowie bei den Kraftstoffeinspritzsystemen eine sogenannte "Grundluft-Bedarfsadaption" im Leerlauf (Einstellen der Leerlaufsolldrehzahl).

Der Diagnoseablauf wird nun am Beispiel des Auslesens der Fehlerspeicher erklärt und wie folgt vorgenommen:
Nach Aufstecken des Testgeräts auf die Reiz- und die Fehlerlampenleitung wird der Zündschalter in Stellung "Zündung ein" gebracht und mittels des Tasters die Reizleitung für 2,5 bis 5 Sek. (Reizzeit) auf Masse gelegt. Das Steuergerät höchster Priorität beginnt dann mit dem Auslesen des ersten Fehlers über die Fehlerlampenleitung in Form eines durch das menschliche Auge erfaß- und auslesbaren Blinkcode-Telegramms, wobei ein Servicemann die Anzahl der Blinkimpulse zählen und diese vier unterschiedlichen Stellen (mit max. 9 Blinkimpulsen pro Stelle) zuordnen muß. Das so erhaltene Codewort vergleicht er mit einer Tabelle, auf der den einzelnen Codewörtern bestimmte Fehler an bestimmten Steuergeräten oder deren Peripherie zugeordnet sind.

Nachdem der Servicemann den Fehlercode erfaßt und notiert hat, kann er durch erneutes Anreizen des Steuergerätes (Reizzeit 2,5 bis 5 Sek.) den nächsten Fehler auslesen, bis am Schluß ein Code "Keine weiteren Fehler vorhanden", erscheint. Er kann darauf hin mittels einer Signalgabe von über 10 Sek. Reizzeit den Fehlerspeicher des Steuergeräts löschen und in gleicher Weise mit dem Auslesen des Fehlerspeichers des Steuergeräts mit nächstniedriger Priorität fortfahren, bis er schließlich alle Fehlerspeicher aller Steuergeräte ausgelesen hat.

Auf ähnliche Weise wird auch die Stellglied- und Schalteingangsdiagnose und die Grundluftbedarfsadaption durchgeführt, bei denen das Blinkcode-Telegramm beispielsweise eine Adresse eines angeregten Stellglieds darstellt. Das Auslesen der Fehler geschieht jedoch streng sequentiell Steuergerät für Steuergerät mit fallender Priorität und Fehler für Fehler, so daß beispielsweise ein direkter Zugriff zu einem bestimmten Steuergerät nicht möglich ist. Ist beispielsweise bekannt, daß an der Klimaanlage des Kraftfahrzeugs ein Fehler aufgetreten ist, so müssen trotzdem zunächst alle Steuergeräte mit höherer Priorität diagnostiziert werden, obwohl dies u. U. gar nicht notwendig ist oder nicht interessiert.

Ebenso ist bei diesem Diagnosesystem ein direkter Bezug des ausgelesenen Fehlers zu einem bestimmten Steuergerät nur schlecht möglich, da das Blinkcode-Telegramm einen Fehler nur allgemein angibt. Hierdurch wird die Fehlerzuordnung und -identifikation unnötig erschwert, beispielsweise, wenn der Servicemann während des Diagnoseverlaufs vergessen hat, welches Steuergerät er gerade diagnostiziert.

Es ist daher Aufgabe der Erfindung, dieses Diagnosesystem bezüglich des Diagnoseablaufs und der Fehleridentifikation zu verbessern, indem der Diagnoseablauf beschleunigt und komfortabler gestaltet und die Fehleridentifikation und -zuordnung erleichtert wird.

Die Aufgabe der Erfindung ist durch die kennzeichnenden Merkmale des Anspruchs 1 gelöst. Weitere, die Erfindung in vorteilhafter Weise ausgestaltende Merkmale sind in den Unteransprüchen enthalten.

Die Vorteile der Erfindung sind vor allem in dem beschleunigten und komfortabler gestalteten Ablauf der Diagnosefunktionen und der verbesserten Fehleridentifikation sowie der verbesserten Zuordnung der Codewörter zu bestimmten Steuergeräten begründet. Weitere Vorteile sind in der Schaffung eines einfachen Testgeräts zu sehen, welches Blinksequenzen von Blinkcode-Telegrammen auszählt, den Code im Klartext anzeigt und Signalgaben definierter Zeitdauer auf Tastendruck auf die Reizleitung aufschalten kann.

Die Erfindung wird anhand von in den Zeichnungen dargestellten Beispielen näher erläutert.
Es zeigt
- Fig. 1: ein Diagnosesystem mit mehreren, in ein Kraftfahrzeug eingebauten Steuergeräten,
- Fig. 2: ein Steuergerät mit allen diagnostizierbaren Funktionen, Sensoren, Stellgliedern und Schalteingängen,
- Fig. 3: ein Zeitdiagramm eines Blinkcode-Telegramms,
- Fig. 4: ein Zeitdiagramm dreier definierter Signalgaben auf einer Reizleitung,
- Fig. 5: ein externes Testgerät.

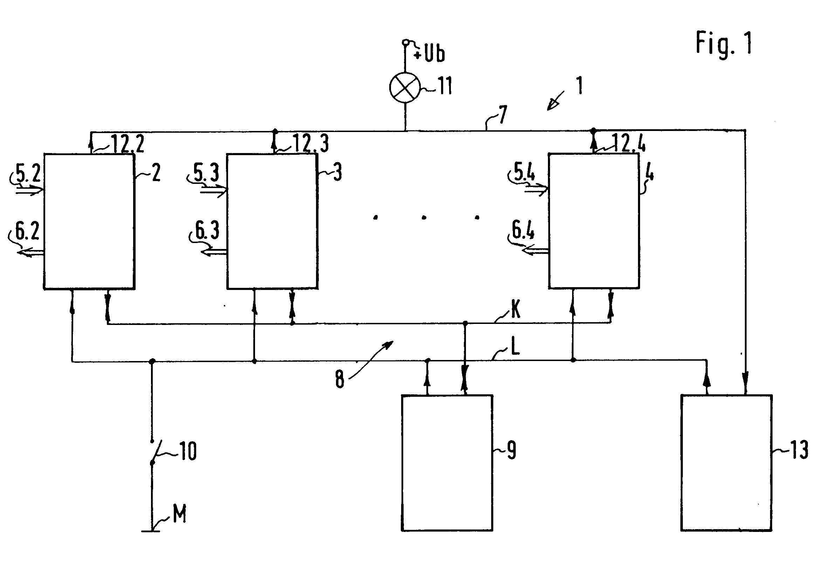

In Fig. 1 ist mit 1 ein Diagnosesystem mit Steuergeräten 2, 3, 4 gezeigt, welche in einem Kraftfahrzeug eingebaut sind. Die Steuergeräte 2 bis 4 sind über Eingänge 5.2 - 5.4 an Sensoren und Schalter und über Ausgänge 6.2 bis 6.4 an Stellglieder angeschlossen.

Zu Diagnosezwecken sind die Steuergeräte 2 bis 4 über eine Fehlerlampenleitung 7 zur Ausgabe von Blinkcode-Telegrammen und über einen Diagnosebus 8 zur Anreizung (Reizleitung L) der Diagnose, und zum Datenverkehr (Kommunikationsleitung K) zwischen den Steuergeräten 2 bis 4 selbst und/oder zwischen den Steuergeräten und einem anschließbaren, rechnergesteuerten Werkstatt-Testgerät 9 oder einem im Fahrzeug integrierten Diagnoserechner, beispielsweise nach der DE-A 35 40 599 (in dieser OS ist auch der Aufbau der Steuergeräte näher beschrieben, so daß hierauf nicht näher eingegangen werden soll).

Eine einfache Diagnosemöglichkeit besteht nun in einem Taster 10, mit dem die Reizleitung L über eine Signalgabe definierter Zeitdauer auf Fahrzeugmasse M gelegt werden kann, um die Diagnosefunktion anzustoßen bzw. Fehlerspeicher zu löschen, wie dies bereits in der Würdigung des Standes der Technik beschrieben wurde. Durch die Masseschaltung erkennen die Steuergeräte, daß es sich um eine Diagnose mit Ausgabe von Blinkcode-Telegrammen und nicht um eine Diagnose mit einem Werkstatt-Testgerät oder einem im Fahrzeug integrierten Testgerät handelt. Die Blinkcode-Telegramme werden von den Steuergeräten über die Fehlerlampenleitung 7 und eine an positive Batteriespannung Ub angeschlossene Fehlerlampe 11 ausgegeben. Hierzu besitzen die Steuergeräte 2 bis 4 sogenannte "Active-Pull-Down"-Ausgänge 12.2 bis 12.4, die die Fehlerlampe 11 zur Signalabgabe gegen Masse schalten.

Mit 13 schließlich ist ein einfaches Testgerät bezeichnet, das weiter unten noch näher beschrieben wird. Es übernimmt auf einfache Weise die Funktion des Tasters 10 (Signalgabe defi-nierter Zeitdauer, Reizzeit) und der Fehlerlampe 11 und zeigt die Fehlercodes direkt in Ziffern an, so daß das Auszählen der Blinkimpulse des Blinkcode-Telegramms entfällt.

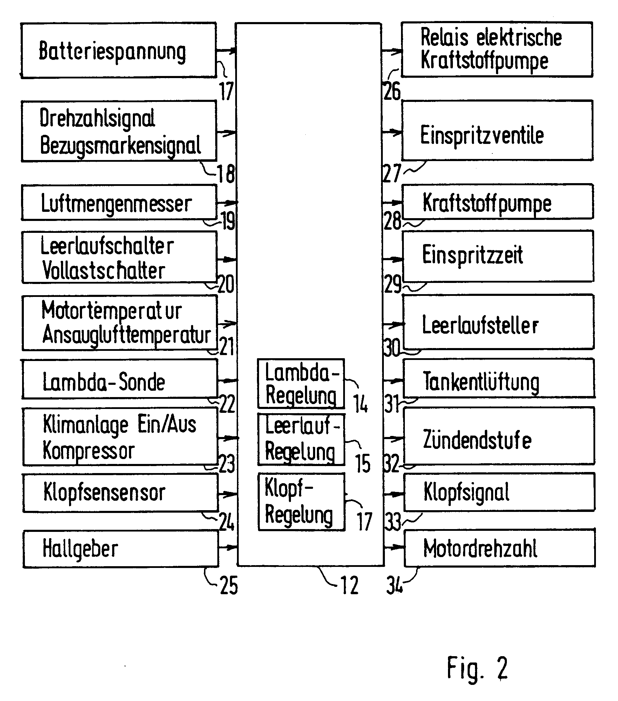

In Fig. 2 ist der Diagnoseumfang eines Steuergeräts am Beispiel eines Motorsteuergeräts 12 gezeigt. Intern diagnostiziert werden können eine Lambda-, 14, eine Leerlauf-, 15 und eine Klopfregelung 16. An Eingangsprüfungen sind vorgesehen: Batteriespannung 17, Drehzahl- und Bezugsmarkensignal 18, Luftmengenmesser 19, Leerlauf- und Vollastschalter 20, Temperatur des Motors und der Ansaugluft 21, Lambda-Sonde 22, Klimaanlagen Ein-Aus-Schalter und Klimaanlagen Kompressor 23, Klopfsensor 24 und Hallgeber 25. Die Ausgangsprüfungen umfassen: Relais elektrische Kraftstoffpumpe 26, Einspritzventile 27, Kraftstoffpumpe 28, Einspritzzeit 29, Leerlaufsteller 30, Tankentlüftungsventil 31, Zündendstufe 32, Klopfsignal 33 und Motordrehzahl 34.

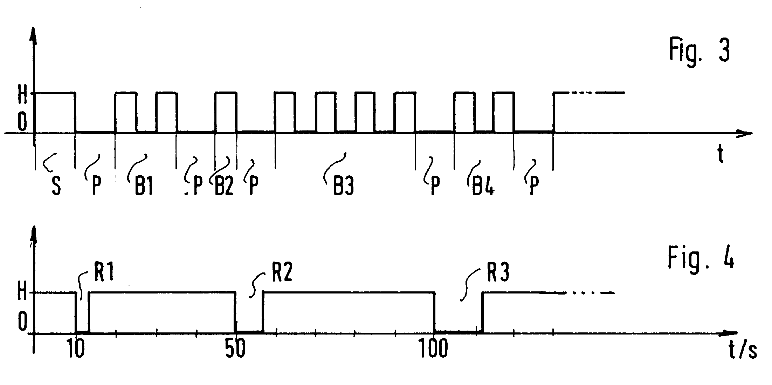

In Fig. 3 ist ein Blinkcode-Telegramm gezeigt. In der Abszisse ist die Zeit t aufgetragen, in Ordinatenrichtung bezeichnet H eine leuchtende, Null eine erloschene Fehlerlampe. Das Blinkcode-Telegramm beginnt mit einem Startblinkimpuls S und einer Pause P, jeweils doppelter Impulsbreite. Anschließend werden die vier Blinksequenzen B1 bis B4, wiederum durch Pausen P doppelter Impulsbreite getrennt, gesendet.

Das gezeigte Impulsdiagramm stellt das Codewort "2 1 4 2" dar; über eine Tabelle kann ihm ein Fehler eines gerade angewählten Steuergeräts zugeordnet werden. Üblicherweise enthält das Codewort hierbei keinen Hinweis auf das defekte Steuergerät und die Art des Fehlers.

Erfindungsgemäß wird nun den einzelnen Blinksequenzen B1 bis B4 des Blinkcode- Telegramms ein bestimmter, spezifischer Informationsgehalt zugewiesen.
- Die erste Blinksequenz gibt eine Steuergeräte-Identifikation, d. h., das gerade diagnostizierte Steuergerät an (hier z. B. "2" entspricht Zündsteuergerät). Es sind bis zu 9 verschiedene Steuergeräte diagnostizierbar:
   Ein Blinkimpuls = Motronic oder LH-Jetronic,
   zwei Blinkimpulse = Zündsteuerung, usw.
- Die zweite Blinksequenz gibt einen Modus der Diagnose an:
   Ein Blinkimpuls = Dauerfehler,
   Zwei Blinkimpulse = zeitweise auftretender Fehler,
   Drei Blinkimpulse = Stellglied und Schalteingabeprüfung,
   Vier Blinkimpulse = Grundluft-Bedarfsadaption,
   Fünf Blinkimpulse = kein Fehler,
   Null Blinkimpulse = Ende der Fehlerausgabe.
   Eine Unterscheidung von max. 9 verschiedenen Modi sind möglich.
- Die dritte und die vierte Blinkseqenz bezeichnen einen Fehlercode. Es können bis zu 99 Codewörter unterschieden werden. In Verbindung mit Null oder fünf Blinkimpulsen in der zweiten Blinksequenz werden keine Blinkimpulse in der dritten und vierten Blinksequenz ausgegeben (kein Fehler, Ende der Fehlerausgabe).

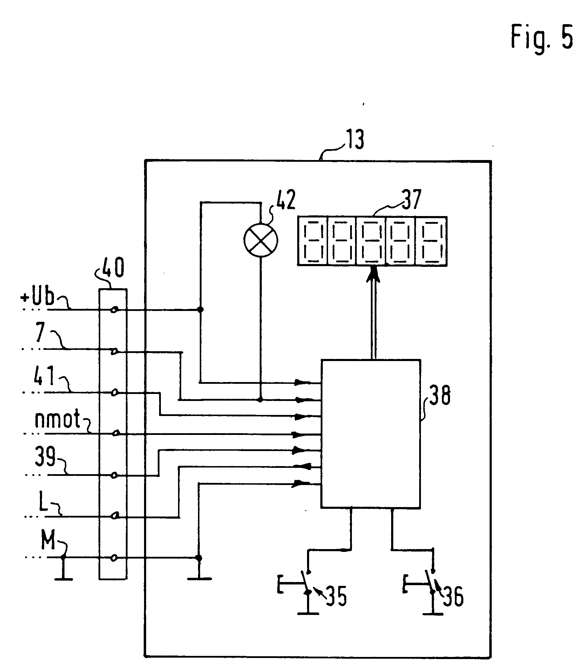

In Fig. 4 sind in einem Zeitdiagramm drei unterschiedliche Signalgaben definierter Zeitdauer (nachfolgend Reizimpulse genannt), gezeigt, mit denen die unterschiedlichen Diagnosefunktionen angestoßen werden können. Ein kurzer Reizimpuls R1 mit einer Zeitdauer von 2,5s bis 5s dient zum Anstoßen der Fehlerausgabe und zum Fortschalten zum nächsten Fehler bzw. Steuergerät. Ein erfindungsgemäß neu eingeführter, mittlerer Reizimpuls R2 von 5s bis 10s Zeitdauer dient zum Abbruch der Diagnose des gerade diagnostizierten Steuergeräts, während ein langer Reizimpuls R3 mit einer Zeitdauer von über 10s ein Löschen des Fehlerspeichers bei vorher angezeigtem Ende der Fehlerausgabe und weitere Diagnosefunktionen initialisiert.

Ein externes Testgerät 10 einfacher Bauart (entsprechend Fig. 1, Bezugszahl 13), ist in Fig. 5 dargestellt. Es umfaßt eine Funktionstaste 35, eine Reiztaste 36 und eine Anzeige 37. Mit der Funktionstaste 35 kann die Zeitdauer der Reizimpulse R1 bis R3 vorgewählt werden; die vorgewählte Reizzeit wird auf der Anzeige 37 angezeigt und mittels der Reiztaste 36 ausgelöst.

Ein eingebauter Mikrorechner 38 prüft die Signale auf der Fehlerlampenleitung 7, erkennt den Startimpuls und die nachfolgende Pause als Kopf des Blinkcode-Telegramms und zählt die nachfolgenden Blinkimpulse der vier durch Pausen getrennten Blinksequenen und zeigt das jeweilige Zählergebnis auf je einer Stelle der Anzeige 37 an.

Hierdurch entfällt u. a. das lästige Auszählen der Blinksequenzen und die Eingabe der Reizimpulse über die Reizleitung L mit der Stoppuhr, so daß nicht nur der Eingabe- und Ausgabekomfort verbessert wird, sondern insbesondere in Verbindung mit der verbesserten Informationsstruktur des Blinkcode-Telegramms, die Sicherheit bei der Erfassung eines Fehlers.

Das Testgerät 13 umfaßt ferner eine Funktion zur Zählung von Klopfimpulsen, welcher durch gleichzeitiges Drücken sowohl der Funktionstaste 35 als auch der Reiztaste 36 ausgelöst werden kann. Ein Zündimpulszähler zählt die Zündimpulse, welche ihm vom Zündgerät oder der Motorsteuerung über eine Leitung nmot zur Verfügung gestellt werden, während ein Klopfzähler die über Leitung 39 von denselben Geräten signalisierten Klopfereignisse der Brennkraftmaschine zählt und anzeigt. Bei Erreichen einer bestimmten Anzahl von Zündimpulsen, beispielsweise 10000, wird die Klopfzählung gestoppt und ein Relativwert von Klopfimpulsen pro 1000 Zündimpulsen auf der Anzeige 37 angezeigt.

Das Testgerät 13 ist über eine im Kraftfahrzeug angeordnete lösbare Verbindung 40 mit Batteriespannung Ub, der Fehlerlampenleitung 7, einer Zündstromleitung 41 (Zündung an), der Leitung nmot, der Leitung 39 (Klopfereignisse), der Reizleitung L und der Fahrzeugmasse verbunden. Zündimpuls- und Klopfzähler können in bekannter Weise als Software- oder als Hardwarezähler ausgeführt sein, wobei letztere auch im Mikrorechner 38 integriert sein können. Die Bereitstellung der Reizimpulse und das Auszählen der Blinkcode-Telegramme erfolgt ebenfalls mittels des Mikrorechners 38. Eine im Testgerät 13 integrierte Fehlerlampe 42 schließlich dient der visuellen Kontrolle der Blinkimpulse.

Die Anzeige 37 ist vorzugsweise als fünfstellige Sieben-Segmentanzeige ausgeführt, wobei vier Stellen zur Anzeige des Codeworts und eine Stelle der Funktionsanzeige (angewählter Reizimpuls R1 bis R3, Klopfzählung, usw.) dient.

## Patentansprüche

1. Diagnoseverfahren für ein Diagnose-System (1) mit wenigstens zwei mit einem Fehlerspeicher und wenigstens einer Selbst-Diagnosefunktion ausgestatteten Steuergeräten (2,3,4) eines Kraftfahrzeugs, wobei
- die Steuergeräte (2,3,4) über eine an eine Fehlerlampe (11) angeschlossene Fehlerlampenleitung (7) und einen wenigstens aus einer Reizleitung (L) bestehenden Diagnosebus (8) miteinander verbunden sind,
- die Diagnose-Funktionen bzw. ein Auslesen der Fehlerspeicher über in ihrer Zeitdauer definierte Signalgaben (R1,R2) auf der Reizleitung (L) bei verschiedenen Schaltzuständen eines Zündschalters ausgelöst werden und
- Informationen über den Zustand des Steuergeräts (2,3,4) und/oder seiner Peripherie über die Fehlerlampe (11) in Form eines durch das menschliche Auge erfaßbaren, aus einem Telegramm-Anfangs-Blinkimpuls (S) und einem diesem nach einer Pause nachfolgenden sich aus vorzugsweise vier durch Pausen getrennten Blinksequenzen (B1..B4) mit jeweils bis zu neun Blinkimpulsen zusammensetzenden Kodewort bestehenden Blinkcode-Telegramms angezeigt werden und
- in einer Diagnosefunktion das Auslesen von Diagnose-Informationen eines jeweiligen Steuergeräts (2,3,4) streng sequentiell erfolgt und die Steuergeräte (2,3,4) mit fallender Priorität nacheinander abgefragt werden,
**dadurch gekennzeichnet, daß**
- durch eine zusätzliche Signalgabe (R2) definierter Zeitdauer eine Diagnose-Funktion eines Steuergeräts (2,3,4) jederzeit abgebrochen und/oder ein nächstes Steuergerät niedrigerer Priorität angewählt werden kann und mit zumindest einer Blinksequenz (B1) das angewählte Steuergerät identifiziert wird.

2. Diagnoseverfahren nach Anspruch 1, **dadurch gekennzeichnet, daß** mit der ersten Blinksequenz (B1) des Blinkcode- Telegramms die Steuergeräteidentifikation, mit der zweiten Blinksequenz (B2) ein Modus, wie z.B. Fehlerart oder Diagnosefunktion, und mit der dritten und der vierten Blinksequenz (B3-B4) ein Fehlerkode angezeigt wird.

3. Diagnoseverfahren nach Anspruch 2, **dadurch gekennzeichnet, daß** bei der Fehlerart zwischen einem lediglich zeitweise und einem dauernd auftretenden Fehler unterschieden wird.

4. Testgerät (13) zur Durchführung eines Diagnoseverfahrens nach Anspruch 1, 2 oder 3, **dadurch gekennzeichnet, daß** es an die Reizleitung (L) und an die Fehlerlampenleitung (7) anschließbar ist, eine Funktionstaste (35), eine Reiztaste (36) und eine Anzeige (37) umfaßt, wobei die Funktionstaste (35) die Zeitdauer der Signalgaben (R1-R3) auf der Reizleitung (L) vorgibt, die Reiztaste (36) die Signalgaben (R1-R3) auslöst und die Anzeige (37) die von wenigstens einer Zählschaltung erfaßte Anzahl der Blinkimpulse der vier Blinksequenzen (B1-B4) und damit das Kodewort wiedergibt.

5. Testgerät nach Anspruch 4, **dadurch gekennzeichnet, daß** das Testgerät (13) ferner eine Zusatzfunktion zur Zählung von Klopfimpulsen einer Brennkraftmaschine des Kraftfahrzeugs umfaßt und hierzu mit einem Klopfzähler und einem Zündimpulszähler ausgestattet ist, wobei der Klopfzähler die während einer bestimmten Anzahl von Zündimpulsen erkannten Klopfereignisse zählt und die Anzeige (37) während der Zählung die Anzahl der Klopfereignisse und bei Erreichen der bestimmten Anzahl von Zündimpulsen ein Relativwert der gezählten Klopfereignisse, bezogen auf die Anzahl von Zündimpulsen, wiedergibt.

6. Testgerät nach Anspruch 5, **dadurch gekennzeichnet, daß** das Testgerät (13) ferner eine Leuchtdiode umfaßt, welche die Blinkimpulse direkt anzeigt.

7. Testgerät nach Anspruch 6, **dadurch gekennzeichnet, daß** das Testgerät (13) eine Funktionsanzeige umfaßt, welche die Zeitdauer der angewählten Signalgabe bzw. einen Status der Zusatzfunktion angibt.

## Claims

1. A diagnosis method for a diagnostic system (1) comprising at least two vehicle-mounted monitors (2, 3, 4) having a fault store and at least one self-diagnosis function, wherein
the monitors (2, 3, 4) are interconnected by way of a fault lamp line (7) connected to a fault lamp (11) and by way of at least one diagnosis bus (8) in the form of a triggering line (L);
the diagnosis functions and a read-out of the fault stores are triggered by way of respective signal transmissions (R1, R2) of defined duration over the triggering line (L) in various positions of an ignition switch;
data about the state of the monitor (2, 3, 4) and/or of its peripheral are displayed by way of the fault lamp (11) in the form of a visually detectable flashing code message comprising a start pulse (S) and, following the same after a pause, a code word embodied by preferably four pause-separated flashing sequences (B1... B4) each having up to nine flashing pulses, and
in a diagnosis function the read-out of diagnosis data of each monitor (2, 3, 4) occurs in a strict sequence and the monitors (2, 3, 4) are sampled seriatim in order of decreasing priority,
characterised in that:
a diagnosis function of a monitor (2, 3, 4) can be interrupted at any time and/or an immediately subsequent monitor of lower priority can be selected by an additional signal transmission (R2) of a defined duration and the selected monitor is identified by at least one flashing sequence (B1).

2. A diagnosis method according to claim 1, characterised in that monitor identification is displayed by the first flashing sequence (B1) of the flashing code message, a mode, such as the nature of the fault or diagnosis function, is displayed by the second flashing sequence (B2) and a fault code is displayed by the third and fourth flashing sequences (B3 - B4).

3. A method according to claim 2, characterised in that in connection with the nature of the fault a differentiation is made between an intermittent fault and a continuous fault.

4. A test apparatus (13) for the performance of a method according to claim 1 or 2 or 3, characterised in that it is connectable to the triggering line (L) and to the fault lamp line (7) and comprises a functions switch (35), a triggering switch (36) and a display (37), the functions switch (35) determining the duration of the signal transmissions (R1 - R3) over the signal line (L), the triggering switch (36) triggering the signal transmissions (R1 - R3), while the display (37) reproduces the number of flashing pulses of the four flashing sequences (B1 - B4) which is detected by at least one counting circuit arrangement - i.e., the display (37) reproduces the code word.

5. A test apparatus according to claim 4, characterised in that it comprises an additional function for counting pinking pulses of an internal combustion engine of the motor vehicle and accordingly has a pinking counter and an ignition pulse counter, the pinking counter counting the pinkings detected during a predetermined number of ignition pulses while the display produces during the counting the number of pinkings and, upon the predetermined number of ignition pulses being reached, a value of the counted pinks relatively to the number of ignition pulses.

6. A test apparatus apparatus according to claim 5, characterised in that it also comprises a luminescent diode which displays the flashing pulses directly.

7. A test apparatus according to claim 6, characterised in that it comprises a functions display indicating the respective duration of the selected signal transmission and a state of the additional function.

## Revendications

1. Procédé de diagnostic pour un système de diagnostic (1) comportant au moins deux appareils de commande (2, 3, 4) équipés d'un mémoire de défaut et d'au moins une fonction d'auto-diagnostic, d'un véhicule automobile, dans lequel
- les appareils de commande (2, 3, 4) sont reliés entre eux par une ligne (7) raccordée à une lampe de défaut et un bus de diagnostic (8) constitué d'une ligne d'excitation (L),
- les fonctions de diagnostic ou une lecture des mémoires de défaut sont déclenchées par des signaux (R1, R2), définis dans leur durée, délivrés sur la ligne d'excitation (L) pour différents états de commutation d'un contacteur d'allumage et
- des informations concernant l'état de l'appareil de commande (2, 3, 4) et/ou de ses périphériques sont affichées par l'intermédiaire de la lampe de défaut (11), sous la forme d'un télégramme à code clignotant, perceptible par l'oeil humain, constitué d'une impulsion de clignotement de début de télégramme (S) et d'un mot codé, faisant suite à cette impulsion après une pause, se composant de préférence de quatre séquences clignotantes (B1...B4) séparées par des pauses avec chacune jusqu'à neuf impulsions clignotantes et
- dans une fonction de diagnostic, la sélection d'informations de diagnostic d'un appareil de commande (2, 3, 4) respectif s'effectue de manière strictement séquentielle et les appareils de commande (2, 3, 4) sont interrogés l'un après l'autre suivant un ordre de priorité décroissant,
caractérisé en ce que
- par des signaux supplémentaires (R2), de durée définie, une fonction de diagnostic d'un appareil de commande (2, 3, 4) est interrompue à tout moment et/ou un appareil de commande suivant, de priorité inférieure, peut être sélectionné et l'appareil de commande sélectionné est identifié avec au moins une séquence de clignotement (B1).

2. Procédé de diagnostic selon la revendication 1, caractérisé en ce que l'identification de l'appareil de commande est affiché avec la première séquence de clignotement (B1) du télégramme à code clignotant, un mode, par exemple un type de défaut ou une fonction de diagnostic est affiché avec la deuxième séquence de clignotement (B2) et un code de défaut est affiché avec la troisième et la quatrième séquences de clignotement (B3 et B4).

3. Procédé de diagnostic selon la revendication 2, caractérisé en ce que le type de défaut fait la distinction entre un défaut survenant uniquement temporairement et un défaut permanent.

4. Testeur (13) pour la mise en oeuvre d'un procédé de diagnostic selon la revendication 1, 2 ou 3, caractérisé en ce qu'il peut être raccordé à la ligne d'excitation (L) et à la ligne de lampe de défaut (7), en ce qu'il comporte une touche de fonction (35), une touche d'excitation (36) et un afficheur (37), la touche de fonction (35) imposant la durée des signaux (R1 à R3) sur la ligne d'excitation (L), la touche d'excitation (36) déclenchant les signaux (R1 à R3) et l'afficheur (37) indiquant le nombre d'impulsions de clignotement, enregistrées par au moins un circuit de comptage, des quatre séquences de clignotement (B1 à B4) et donc le mot codé.

5. Testeur selon la revendication 4, caractérisé en ce que le testeur (13) comporte en outre une fonction supplémentaire destinée à compter les impulsions de détonation d'un moteur à combustion interne du véhicule automobile et est équipé à cet effet d'un compteur de détonations et d'un compteur d'impulsions d'allumage, le compteur de détonations comptant les détonations détectées pendant un nombre déterminé d'impulsions d'allumage et l'afficheur (37) indiquant pendant le comptage, le nombre de détonations et, lorsqu'est atteint le nombre déterminé d'impulsions d'allumage, une valeur relative des détonations comptées, rapportée au nombre d'impulsions d'allumage.

6. Testeur selon la revendication 5, caractérisé en ce que le testeur (13) comporte en outre une diode luminescente qui indique directement les impulsions de clignotement.

7. Testeur selon la revendication 6, caractérisé en ce que le testeur (13) comporte une indication de fonction qui indique la durée des signaux sélectionnés ou un état de la fonction supplémentaire.
